Europäisches Patentamt

European Patent Office

Office européen des brevets

(11) Publication number: **0 337 596**
A2

# EUROPEAN PATENT APPLICATION

(21) Application number: 89301636.0

(51) Int. Cl.4: **H01B 1/14**

(22) Date of filing: 20.02.89

(30) Priority: 15.04.88 JP 91256/88

(43) Date of publication of application:
18.10.89 Bulletin 89/42

(84) Designated Contracting States:
**CH DE GB LI**

(71) Applicant: UBE INDUSTRIES, LTD.
32-12, Nishihonmachi 1-chome
Ube-shi Yamaguchi-ken 755(JP)

(72) Inventor: Nitta, Kuniaki
c/o Ube Industries Ltd 12-32 Nishihonmachi
1 chome
Ube-shi Yamaguchi(JP)
Inventor: Imaoka, Ryoichi c/o Ube Industries
Ltd.
12-32 Nishihonmachi 1 chome
Ube-shi Yamaguchi(JP)

(74) Representative: Fisher, Bernard et al
Raworth, Moss & Cook 36 Sydenham Road
Croydon Surrey CR0 2EF(GB)

(54) Electroconductive magnesia powder and process for preparation thereof.

(57) An electroconductive magnesia powder which comprises a spherical granulation product having a diameter of 0.5 to 100 μm, the surface of which is uniformly coated with silver in an amount of 3 to 70% by weight. This silver-coated magnesia powder has an electroconductivity comparable to that of the silver powder and is valuable as an electroconductive filler for an electroconductive paint, an electroconductive adhesive and an electroconductive elastomer. This silver-coated magnesia powder is prepared by once forming a silver coating in the form of a silver oxide and subjecting the silver oxide coating to a reducing treatment.

EP 0 337 596 A2

Xerox Copy Centre

## ELECTROCONDUCTIVE MAGNESIA POWDER AND PROCESS FOR PREPARATION THEREOF

## BACKGROUND OF THE INVENTION

### 1. Field of the Invention

The present invention relates to an electroconductive magnesia powder used as an electroconductive filler for an electroconductive paint, electroconductive adhesive or electroconductive elastomer used for various electronic appliances, and a process for the preparation thereof.

### 2. Description of the Related Art

The remarkable development of the electronic industry has created an increasing demand for electroconductive fillers. Most electroconductive fillers used at the present are the silver powder type, as silver has the highest electroconductivity among metals and has an excellent weatherability, and accordingly, when silver is used as the electroconductive filler, the formed coating has an excellent electroconductivity and weatherability. When, however, a powder is formed by pulverizing a lump of silver, a great deal of effort must be made to arrange the particle size and shape, and thus the industry is not satisfied with this filler, from the viewpoint of the resource and cost. Accordingly, attempts have been made to substitute a part of silver with a base metal such as copper or nickel (see, for example, Japanese Examined Patent Publication No. 60-17392), but the surface of a calcined body obtained by molding and calcination using an electroconductive paint composed of a mixture of silver and copper powders is formed of a silver/copper solid solution and copper oxide, and therefore, the electroconductivity is much lower than that of the product composed solely of a silver powder, and thus the practical application causes problems.

Under this background, intensive experiments have been carried out on the coating of the surface of a powder of copper, graphite, glass, silica, alumina, titanate or the like with silver (see, for example, Japanese Unexamined Patent Publication No. 60-100679, Japanese Unexamined Patent Publication No. 60-181294 and Japanese Unexamined Patent Publication No. 61-3802).

In the chemical plating method which is the most popular method of forming the coating layer, for example, in a method in which a powder as mentioned above is dispersed in a solution comprising silver nitrate, aqueous ammonia and a reducing agent, and a silver mirror reaction occurs on the surface of the powder, since the precipitation of the silver is slow, a long time is required to obtain a desired coating. Furthermore, since silver is precipitated in an ultrafine particulate form, it is difficult to obtain a dense coating.

## SUMMARY OF THE INVENTION

Therefore, a primary object of the present invention is to provide a novel silver-coated magnesia powder in which the above-mentioned defects are overcome, and a process for the preparation thereof.

In accordance with one aspect of the present invention, there is provided an electroconductive magnesia powder which comprises a spherical magnesia granulation product having a diameter of 0.5 to 100 $\mu$m, and the surface of which is uniformly coated with silver in an amount of 3 to 70% by weight.

In accordance with another aspect of the present invention, there is provided a process for the preparation of an electroconductive magnesia powder, which comprises granulating a fine powder of magnesia having a specific surface area of 1 to 180 $m^2/g$ to form a spherical magnesia granulation product having a diameter of 0.5 to 100 $\mu$m, dispersing the granulation product in an organic solvent, gradually dropping a silver compound solution comprising a silver compound, an organic solvent, and water into the dispersion under refluxing, heating and stirring to precipitate a dense and uniform silver oxide, onto the granulation product, recovering, washing and drying, and subjecting the silver oxide to a reducing treatment in a reducing atmosphere maintained at a temperature lower than 275° C

The present inventors carried out an investigation with a view to solving the problems involved in the conventional technique and found that, if silver is coated in the form of silver oxide and this silver oxide coating is then subjected to a reducing treatment, a dense and uniform silver coating can be promptly formed on the surface of a magnesia granulation product. The present invention has been completed based on this finding.

The present invention will now be described in detail.

## DESCRIPTION OF THE PREFERRED EMBODIMENTS

The magnesia granulation particles used in the preparation process of the present invention are obtained by granulating a fine magnesia powder having a specific surface area of 1 to 180 $m^2/g$. The granulation product has a spherical shape and preferably the diameter is 0.5 to 100 $\mu m$. The process for preparing the fine magnesia powder having a specific surface area of 1 to 180 $m^2/g$ is not particularly critical, but the gas phase oxidation process in which the preparation of an ultrafine powder is possible and the particle size can be controlled is preferred. If the shape of the granulation product is not spherical or the diameter is smaller than $0.5\mu m$, since the surface to be covered with silver is increased, it is technically difficult to form a uniform coating, and thus the production becomes economically disadvantageous. If the diameter of the granulation product exceeds 100 $\mu m$, the function of the electroconductive filler for a paint or adhesive is lost, and thus too large a diameter is not preferred.

A silver compound having a high water solubility is preferably used as the silver compound in the present invention, and silver nitrate or silver sulfate is used. If a silver compound having a low water solubility is used, the amount of solution necessary is increased and the production becomes economically disadvantageous.

Any organic solvent not destroying the magnesia granulation product chemically or physically can be used as the organic solvent in the present invention. In general, however, alcohols such as methyl alcohol, ethyl alcohol and isopropyl alcohol are used.

In the present invention, the magnesia granulation product powder is dispersed in the organic solvent, and the dispersion is formed under refluxing, heating and stirring. The temperature of the dispersion is optionally within 5 to 75°C, but to advance the reaction promptly, preferably the temperature of the dispersion is 50 to 75°C. In this case, it is sufficient if the amount of the organic solvent is enough to thoroughly disperse the magnesia granulation product powder, and in general, the organic solvent is used in an amount of at least 50 ml per gram of the magnesia granulation product powder. If a solution comprising a silver compound, an organic solvent, and water is gradually dropped into this dispersion, and the mixture is retained, a silver oxide-coated magnesia granulation product powder is obtained. The amount of water in the solution is determined according to the solubility of the silver compound. For example, where silver nitrate is used as the silver compound, the amount of the organic solvent in the solution is at least 20% by volume based on the solution. The silver compound is added in an amount such that the content of silver in the final silver-coated magnesia powder is 3 to 70% by weight. If the silver content is too low and below the above-mentioned range, the electroconductivity is drastically reduced and the practical utility is lost. If the silver content is more than the above-mentioned range, an electroconductive magnesia powder having further enhanced characteristics can not be obtained and the production becomes economically disadvantageous.

The obtained silver oxide-coated magnesia powder is recovered by decantation, filtration or the like, and after washing and drying, a silver-coated magnesia powder is obtained by a reducing treatment. The reducing treatment is carried out at a temperature lower than 275°C in a hydrogen current, in vacuo or in a carbon monoxide current. Preferably, the reducing treatment is carried out at 80 to 250°C in a hydrogen current.

In the preparation process of the present invention, by adjusting the synthesis conditions such as the concentration of the solution containing a silver ion and the dispersing temperature, the number of nuclei of silver oxide formed on the magnesia granulation particles is controlled, whereby the thickness of the silver oxide coating can be controlled. The formed silver oxide coating has dense and uniform properties. The reaction can be expressed by the following formulae (1) and (2):

$$AgNO_3 \rightarrow Ag^+ + NO_3^-$$
$$Ag_2SO_4 \rightarrow 2Ag^+ + SO_4^{2-} \quad (1)$$
$$2Ag^+ + 2NO_3^- + MgO \rightarrow Mg(NO_3)_2 + Ag_2O$$
$$2Ag^+ + SO_4^{2-} + MgO \rightarrow MgSO_4 + Ag_2O \quad (2)$$

The silver oxide-coated magnesia powder is subjected to the reducing treatment as expressed by the following formula (3):

$$Ag_2O + H_2 \rightarrow 2Ag + H_2O \quad (3)$$

In the silver-coated magnesia powder obtained by this reducing treatment, the state of the original silver oxide coating is maintained as it is, and the silver coating has a dense film structure.

The silver coating of the so-obtained silver-coated magnesia powder is uniform without unevenness, and is dense, and therefore, the silver-coated magnesia powder has an excellent electroconductivity and weatherability comparable to those of the silver powder.

The present invention will now be described with reference to the following examples, that by no means limit the scope of the invention.

Example 1

In 200 ml of water was dissolved 2.90 g of silver nitrate, and 100 ml of ethyl alcohol was added to the solution to form a silver nitrate solution. Separately, an ultra-fine powder of magnesia having a surface area of 30 m²/g was granulated by using a spray drier. Then, 5.0 g of the obtained spherical granulation powder (having an average particle size of 5 μm) was dispersed in 400 ml of ethyl alcohol and the dispersion was maintained at 70°C under refluxing, heating and stirring. The entire amount of the silver nitrate solution prepared above was dropped into this dispersion over a period of 30 minutes and the mixture was retained for 30 minutes. Then, the liquid phase was removed by decantation, and the recovered solid was washed with 500 ml of water and dried at 70°C to obtain a blackish brown silver oxide-coated magnesia powder.

The silver oxide-coated magnesia powder was placed on a quartz board and the reducing treatment was carried out at 100°C in a hydrogen current for 1 hour to obtain a greyish white silver-coated magnesia powder. When this powder was examined by a scanning type electron microscope, it was found that the magnesia particles were not exposed to the surface and the magnesia particles were covered with a uniform continuous coating of silver. The silver content in this silver-coated magnesia powder was about 28% by weight.

The electroconductivity of the silver-coated magnesia powder was evaluated according to the following method.

The silver-coated magnesia powder was packed in a glass tube having a diameter of 2 mm and a length of 40 mm, electrodes were arranged on both the ends of the glass tube, the resistance between the electrodes was determined by the direct current two-terminal method, and the specific resistance of the sample was calculated. The results are shown in Table 1.

Example 2

Using a spray drier, an ultra-fine powder having a specific surface area of 120 m²/g, which was prepared by the gas phase oxidation method, was granulated to obtain a spherical granulation product powder having an average particle size of 0.5 μm. A silver-coated magnesia powder was prepared in the same manner as described in Example 1 except that the so-obtained spherical granulation product powder was used and 14.20 g of silver nitrate was used.

It was confirmed that the silver coating was dense and uniform in the so-obtained silver-coated magnesia powder. The electroconductivity of this powder was evaluated in the same manner as described in Example 1. The results are shown in Table 1. The silver content in the silver-coated magnesia powder was about 68% by weight.

Example 3

An ultra-fine magnesia powder having a specific surface area of 2 m²/g, which was prepared by the gas phase oxidation method, was granulated by using a spray drier to obtain a spherical granulation product powder having an average particle size of 50 μm. A silver-coated magnesia was prepared in the same manner as described in Example 1 except that this spherical granulation product powder was used and 0.27 g of silver nitrate was used.

It was confirmed that the silver coating was dense and uniform in the so-obtained silver-coated magnesia powder. The electroconductivity of this powder was evaluated in the same manner as described in Example 1. The results are shown in Table 1. The silver content in the silver-coated magnesia powder was about 3% by weight.

Example 4

4

A silver-coated magnesia powder was prepared in the same manner as described in Example 1 except that 14.01 g of silver nitrate was used. The electroconductivity of the silver-coated magnesia powder was evaluated in the same manner as described in Example 1. The results are shown in Table 1.

The silver content in the silver-coated magnesia powder was about 65% by weight.

Example 5

Ultra-fine magnesia having a specific surface area of 2 m²/g, which was prepared by the gas phase oxidation method, was granulated by a spray drier to obtain a spherical granulation product powder having an average particle size of 50 μm. A silver-coated magnesia powder was prepared in the same manner as described in Example 1 except that the so-obtained spherical granulation product powder was used and 1.48 g of silver nitrate was used.

It was confirmed that the silver coating was dense and uniform in the so-obtained silver-coated magnesia powder. The electroconductivity of the silver-coated magnesia powder was evaluated in the same manner as described in Example 1. The results are shown in Table 1. The silver content in the silver-coated magnesia powder was about 15% by weight.

Example 6

A silver-coated magnesia powder was prepared in the same manner as described in Example 1 except that 2.96 g of silver sulfate was used as the starting silver compound, and the electroconductivity of the silver- coated magnesia powder was evaluated in the same manner as described in Example 1. The results are shown in Table 1.

The silver content in the silver-coated magnesia powder was about 27% by weight.

Example 7

A silver-coated magnesia powder was prepared in the same manner as described in Example 1 except that 500 ml as a whole of isopropyl alcohol was used as the solvent. The electroconductivity of the silver-coated magnesia powder was evaluated in the same manner as described in Example 1. The results are shown in Table 1.

Example 8

A silver-coated magnesia powder was prepared in the same manner as described in Example 1 except that the temperature of the reaction between the dispersion and the silver solution was changed to 20°C and the reaction time was changed to 5 hours. The electroconductivity of the silver-coated magnesia was evaluated in the same manner as described in Example 1. The results are shown in Table 1.

Example 9

A silver-coated magnesia powder was prepared in the same manner as described in Example 1 except that the reducing treatment was carried out at 250°C in a hydrogen current for 1 hour. The electroconductivity was evaluated in the same manner as described in Example 1. The results are shown in Table 1.

Example 10

A silver-coated magnesia powder was prepared in the same manner as described in Example 1 except that the reducing treatment was carried out at 250°C in vacuo for 1 hour. The electroconductivity of the silver-coated magnesia powder was evaluated in the same manner as described in Example 1. The results are shown in Table 1.

Comparative Example 1

In 100 ml of water was dissolved 2.90 g of silver nitrate, and aqueous ammonia was added to the solution until a precipitate once formed by addition of aqueous ammonia disappeared. Then, 4 ml of formalin (40% HCHO) was added to the so-prepared transparent ammonia solution of silver nitrate to form a silver mirror solution. Then, 5 g of a magnesia powder having an average particle size of 5 μm was dispersed in this solution, and the dispersion was stirred for 2 hours to cause the silver mirror reaction on the surface of the powder and form a silver coating. The solid was recovered by decantation, washed with 500 ml of water and dried at 70°C. The electroconductivity of the powder was evaluated in the same manner as described in Example 1. The specific resistance was very high and the measured value was not stable. By the scanning type electron microscope observation, it was confirmed that the coating of magnesia particles by the formed silver particles was not uniform and was not continuous. The results are shown in Table 2.

Comparative Example 2

Ultra-fine magnesia having a specific surface area of 120 m²/g, which was prepared according to the gas phase oxidation method, was granulated by using a spray drier to obtain a spherical granulation product powder having an average particle size of 0.5 μm. A silver-coated magnesia powder was prepared in the same manner as described in Example 1 except that the so-obtained spherical granulation product powder was used and 16.81 g of silver nitrate was used.

It was confirmed that the silver coating was dense and uniform. The electroconductivity of the powder was evaluated in the same manner as described in Example 1. The results are shown in Table 2. The silver content in the silver-coated magnesia powder was about 78% by weight.

Comparative Example 3

Ultra-fine magnesia having a specific surface area of 2 m²/g, which was prepared according to the gas phase oxidation method, was granulated by using a spray drier to obtain a spherical granulation product having an average particle size of 50 μm. A silver-coated magnesia powder was prepared in the same manner as described in Example 1 except that the so-obtained spherical granulation product powder was used and 0.08 g of silver nitrate was used.

The electroconductivity of the powder was evaluated in the same manner as described in Example 1. The results are shown in Table 2. The silver content in the silver-coated magnesia powder was about 1% by weight.

Comparative Examples 4 and 5

The electroconductivity was evaluated in the same manner as described in Example 1 by using a magnesia granulation product powder having an average particle size of 5 μm (Comparative Example 4) and a silver powder having an average particle size of 5 μm (Comparative Example 5). The results are shown in Table 2.

Table 1

| Example No. | Electroconductivity (specific resistance, Ω-cm) of Silver-Coated Magnesia Powder |
|---|---|
| 1 | $5 \times 10^{-3}$ |
| 2 | $4 \times 10^{-3}$ |
| 3 | $4 \times 10^{-3}$ |
| 4 | $8 \times 10^{-4}$ |
| 5 | $7 \times 10^{-4}$ |
| 6 | $6 \times 10^{-3}$ |
| 7 | $5 \times 10^{-3}$ |
| 8 | $5 \times 10^{-2}$ |
| 9 | $7 \times 10^{-3}$ |
| 10 | $6 \times 10^{-2}$ |

Table 2

| Comparative Example No. | Electroconductivity (specific resistance, Ω-cm) of Various Powders |
|---|---|
| 1 | $5 \times 10^{+4}$ |
| 2 | $7 \times 10^{-4}$ |
| 3 | $3 \times 10^{+4}$ |
| 4 | $8 \times 10^{+14}$ |
| 5 | $5 \times 10^{-4}$ |

As apparent from the above description, the silver-coated magnesia powder of the present invention has an electroconductivity comparable to that of the silver powder, and thus is very valuable as an electroconductive filler for an electroconductive paint, an electroconductive adhesive, an electroconductive elastomer and the like.

The preparation process of the present invention has excellent characteristics such as a high coating-forming speed and a high density of the formed coating.

## Claims

1. An electroconductive magnesia powder which comprises a spherical magnesia granulation product having a diameter of 0.5 to 100 μm, a surface of which is coated with silver in an amount of 3 to 70% by weight.

2. An electroconductive magnesia powder as claimed in claim 1, wherein the magnesia granulation product is obtained by granulating a fine magnesia powder having a specific surface area of 1 to 180 m²/g.

3. An electroconductive magnesia powder as claimed in claim 1, wherein silver is coated by firstly coating in the form of silver oxide and then subjecting the silver oxide to a reducing treatment.

4. A process for the preparation of an electroconductive magnesia powder, which comprises granulating a fine powder of magnesia having a specific surface area of 1 to 180 m²/g to form a spherical magnesia granulation product having a diameter of 0.5 to 100 μm, dispersing the granulation product in an organic solvent, gradually dropping a silver compound solution comprising a silver compound, an organic solvent and water into the dispersion under refluxing, heating and stirring to precipitate a dense and uniform silver oxide onto the granulation product, recovering, washing and drying, and subjecting the silver oxide to a reducing treatment in a reducing atmosphere maintained at a temperature lower than 275° C.

5. A process according to claim 4, wherein the silver compound is selected from silver nitrate and silver sulfate.

6. A process according to claim 4, wherein the organic solvent is selected from methyl alcohol, ethyl alcohol and isopropyl alcohol.

7

7. A process according to claim 4, wherein the temperature of the dispersion is 5 to 75°C.

8. A process according to claim 7, wherein the temperature is 50 to 75°C.

9. A process according to claim 4, wherein the amount of the organic solvent in the dispersion is at least 50 ml per gram of the magnesia granulation product.

10. A process according to claim 4, wherein the amount of the organic solvent in the silver compound solution is at least 20% by volume based on the solution.

11. A process according to claim 4, wherein the silver compound is employed in an amount such that the content of silver in the resulting silver-coated magnesia powder is 3 to 70% by weight.

12. A process according to claim 4, wherein the reducing treatment is carried out in a hydrogen current, in vacuo or in a carbon monoxide current.

13. A process according to claim 12, wherein the reducing treatment is carried out at 80 to 250°C in a hydrogen current.